# EUROPÄISCHE PATENTSCHRIFT

(11) **EP 2 845 235 B1**
(45) Veröffentlichungstag und Bekanntmachung des Hinweises auf die Patenterteilung: **28.06.2017**
(21) Anmeldenummer: 13707885.3
(22) Anmeldetag: 07.03.2013
(51) Int. Cl.: H01L 33/64, H05K 1/02

(54) **LED-ANORDNUNG**
LED ARRANGEMENT
ENSEMBLE DEL

(30) Priorität: 30.04.2012 DE 102012207166
(43) Veröffentlichungstag der Anmeldung: 11.03.2015
(73) Patentinhaber: Tridonic Jennersdorf GmbH, 8380 Jennersdorf (AT); AT & S Austria Technologie & Systemtechnik Aktiengesellschaft, 8700 Leoben-Hinterberg (AT)
(72) Erfinder: HARTMANN, Paul, A-8160 Weiz (AT); JANISCH-LANG, Franz, A-8313 Breitenfeld (AT); KRENN, Günther, A-2700 Wiener Neustadt (AT); STAHR, Johannes, A-8605 St. Lorenzen (AT)
(74) Vertreter: Rupp, Christian
(86) Internationale Anmeldenummer: PCT/EP2013/054620
(87) Internationale Veröffentlichungsnummer: WO 2013/164113

(56) Entgegenhaltungen:
- WO-A1-2008/154952
- DE-A1-102008 016 458
- US-A1- 2003 189 830
- US-A1- 2008 180 014

## Beschreibung

Die vorliegende Erfindung betrifft eine LED-Anordnung (LED: Licht emittierende Diode) mit einem Rahmenträger, wie insbesondere einer Leiterplatte, einem Kühlkörper und einem mit dem Kühlkörper in Verbindung stehenden LED-Modul, welches elektrisch über den Rahmenträger kontaktiert ist, und einen Rahmenträger (z.B. Leiterplatte) mit Kühlkörper. Eine solche Anordnung ist aus der Druckschrift DE 10 2008 016 458 A1 bekannt. Beim Betrieb eines LED-Moduls entsteht grundsätzlich Wärme, und zwar insbesondere durch die LED bzw. die LEDs selbst, aber auch durch die Versorgungsschaltung ("Treiberschaltung") für die LED(s). Diese Wärme wird zumindest teilweise von den genannten Bauteilen an umgebende Bauteile oder an die umgebende Luft übertragen. Um eine möglichst hohe Effizienz des LED-Moduls, Farbstabilität, ggf. bei weißen LEDs Farbtemperaturstabilität sowie eine möglichst lange Lebensdauer der LED(s) zu ermöglichen, ist es erwünscht, dass die Wärme effektiv und effizient von dem LED-Modul (bzw. dessen LED-Chip) abgeleitet wird, so dass die Temperatur der LED nicht über ein gewisses Maß hinaus ansteigt. Hierzu werden gewöhnlich separate Kühlkörper vorgesehen, auf denen die LED-Anordnung in thermischen Kontakt vorgesehen wird. Solche Kühlkörper sind im Vergleich zu den zu kühlenden LED-Modulen vergleichsweise groß, was eine insgesamt vergrößerte LED-Anordnung zur Folge hat.

Es ist daher eine Aufgabe der Erfindung, eine LED-Anordnung mit einem Kühlkörper bereitzustellen, welche bei guter (also effektiver und effizienter) Wärmeabfuhr einen kompakten Aufbau aufweist.

Diese Aufgabe wird durch den Gegenstand des unabhängigen Anspruchs gelöst. Die abhängigen Ansprüche bilden den zentralen Gedanken der Erfindung in besonders vorteilhafter Weise weiter.

Gemäß einem ersten Aspekt der Erfindung wird eine LED-Anordnung vorgeschlagen, welche einen Rahmenträger, insbesondere eine Leiterplatte, und einen Kühlkörper aufweist. Der Kühlkörper ist in einer Aussparung in dem Rahmenträger vorgesehen. Ferner weist die LED-Anordnung wenigstens ein LED-Modul auf, welches über den Rahmenträger elektrisch kontaktiert ist. Das LED-Modul ist ferner wenigstens seitlich (also wenigstens mit einem Teilbereich einer seiner Seiten) mit dem Kühlkörper thermisch kontaktiert, um einen guten Wärmefluss von dem LED-Modul zum Kühlkörper zu gewährleisten. Das LED-Modul ist in einer Ausnehmung des Kühlkörpers angeordnet und von diesem an wenigstens zwei Seiten seitlich umgeben und thermisch kontaktiert. Erfindungsgemäß steht dabei der Kühlkörper an der Seite des Rahmenträgers, an der das LED-Modul vorgesehen ist, vom Rahmenträger hervor. Gemäß einem zweiten Aspekt der Erfindung wird ein Rahmenträger für ein LED-Modul, insbesondere eine Leiterplatte, vorgeschlagen, welcher einen Kühlkörper aufweist, welcher in einer Aussparung in dem Rahmenträger derart vorgesehen ist, dass ein über den Rahmenträger elektrisch kontaktiertes LED-Modul wenigstens seitlich mit dem Kühlkörper thermisch kontaktiert sein kann, um einen guten Wärmefluss von dem LED-Modul zum Kühlkörper zu gewährleisten. Der Kühlkörper weist eine Ausnehmung auf, in das das LED-Modul anordenbar ist, um vom Kühlkörper an wenigstens zwei Seiten seitlich umgeben und thermisch kontaktiert zu werden. Erfindungsgemäß steht dabei der Kühlkörper an der Seite des Rahmenträgers, an der das LED-Modul vorgesehen ist, vom Rahmenträger hervor. Die Erfindung ist folglich sowohl auf den Rahmenträger mit Kühlkörper selbst (Leiterplatten-Hybridaufbau) als auch auf den Rahmenträger mit Kühlkörper und LED-Modul im Verbund (LED-Anordnung) gerichtet.

Mittels der Erfindung wird somit ein aus einem Träger (Leiterplatte) und einem darin integrierten Kühlkörper bestehender Leiterplatten-Hybridaufbau bereitgestellt, der eine optimale Wärmeabfuhr der von einem LED-Modul erzeugten Wärme ermöglicht, ohne einen weiteren externen bzw. separaten Kühlkörper vorzusehen. Hierzu wird die von dem LED-Modul erzeugte Wärme direkt über deren Seitenwände an den in dem Träger integrierten Kühlkörper abgeführt. Die integrierte Bauweise hat zudem den Vorteil, dass eine besonders geringe Einbauhöhe des Gesamtsystems, also der gesamten LED-Anordnung, erzielt wird. Ferner kann bei hoher Wärmeabfuhr und kompakten Aufbau das LED-Modul als oberflächenmontiertes Bauteil (SMD-Bauteil) auf den Träger gelötet werden, ohne zusätzlichen Verbindungen (z.B. Bonddrähte) vorzusehen.

Weitere Merkmale, Vorteile und Eigenschaften der Erfindung werden im Folgenden anhand von Ausführungsbeispielen und der Figuren der begleitenden Zeichnungen erläutert.
- Figur 1: zeigt eine Draufsicht auf eine LED-Anordnung gemäß einem ersten Ausführungsbeispiel der Erfindung,
- Figur 2: zeigt eine Draufsicht auf eine LED-Anordnung gemäß einem zweiten Ausführungsbeispiel der Erfindung
- Figur 3: zeigt eine seitliche Schnittansicht einer LED-Anordnung gemäß einem dritten Ausführungsbeispiel der Erfindung,
- Figur 4: zeigt eine seitliche Schnittansicht einer LED-Anordnung gemäß einem vierten Ausführungsbeispiel der Erfindung
- Figur 5: zeigt eine seitliche Schnittansicht einer LED-Anordnung gemäß einem fünften Ausführungsbeispiel der Erfindung.

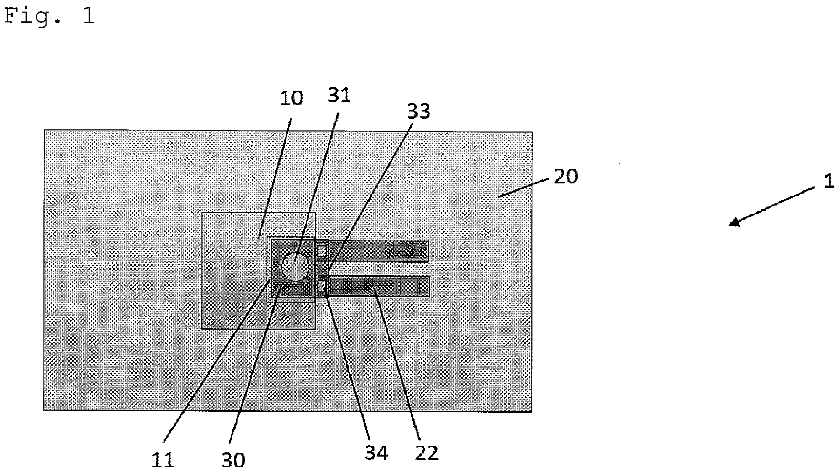

Figuren 1 bis 5 zeigen jeweils ein Ausführungsbeispiel einer LED-Anordnung 1 gemäß der Erfindung. Die LED-Anordnung 1 weist einen erfindungsgemäßen Träger bzw. Rahmenträger 20 auf. Der Träger 20 ist Teil der LED-Anordnung 1, ist aber auch einzeln von der Erfindung umfasst. Der Träger 20 ist vorzugsweise eine kostengünstige Leiterplatte, wie bspw. eine CEM1- oder FR4-Leiterplatte. Der Träger 20 kann beispielsweise als großflächige Leiterplatte eingesetzt werden, an die selbst keine speziellen Anforderungen wie z.B. gute thermische Leitfähigkeit oder gut Lichtreflexion gestellt werden.

Die LED-Anordnung 1 weist des Weiteren einen Kühlkörper 10 auf. Der Kühlkörper 10 ist aus einem thermisch gut leitenden (also gut Wärme-leitenden) Material hergestellt, wie z.B. aus Aluminium oder Kupfer.

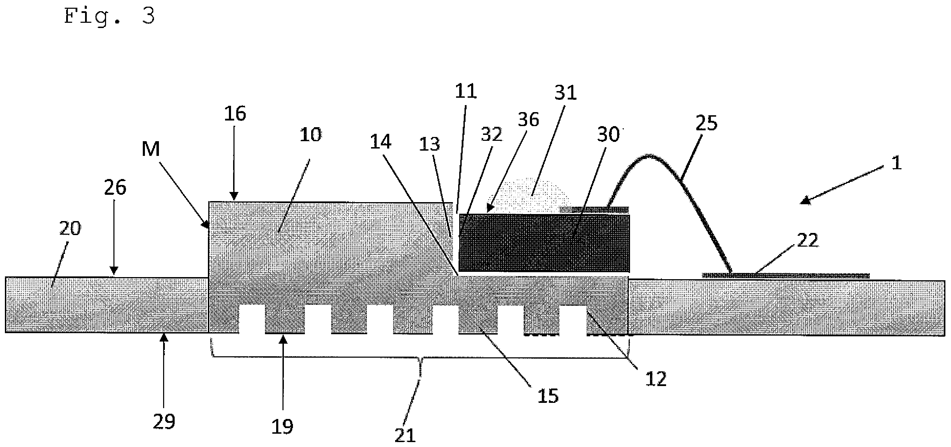

Wie insbesondere in den Figuren 3 bis 5 zu erkennen ist, weist der Träger 20 eine Aussparung 21 auf, in die der Kühlkörper 10 vorgesehen, also integriert bzw. eingesetzt ist. Der Kühlkörper 10 kann hierzu vorzugsweise mittels Einpressen, Laminieren oder Kleben in die Aussparung 21 des Trägers 20 eingesetzt werden. Besonders vorzugsweise steht der Kühlkörper 10, genauer die von dem Träger 20 umgebenden Mantelflächenbereiche des Kühlkörpers 10, in flächigem und vorzugsweise thermischem Kontakt mit der Aussparung 21 des Trägers 20, genauer mit den die Aussparung 21 bildenden Wänden oder Wandbereichen des Trägers 20. Da der Kühlkörper 10 in dem Träger 20 integriert vorgesehen ist, hat die LED-Anordnung 1 eine vergleichsweise geringe Höhe, wodurch wiederum eine geringe Einbauhöhe der LED-Anordnung 1 erreicht werden kann. Eine derartige Anordnung von Träger 20 und Kühlkörper 10 kann auch als Hybrid-Träger bzw. Hybrid-Leiterplatte bezeichnet werden.

Wie den Ausführungsbeispielen der Figuren 3 bis 5 zu entnehmen ist, steht der Kühlkörper 10 erfindungsgemäß wenigstens an einer Seite 26 des Trägers 20 vor, während er auf der gegenüberliegenden Seite 29 vorzugsweise mit dem Träger 20 bündig angeordnet ist.

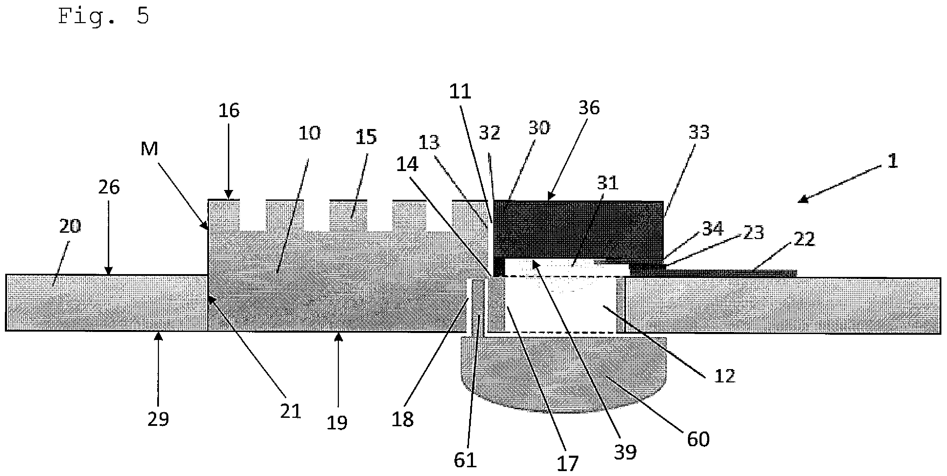

Um die wärmeleitende Oberfläche des Kühlkörpers 10 zu vergrößern, kann der Kühlkörper 10 zusätzliche oder integral ausgebildete Kühlelemente 15 aufweisen; vorzugsweise Kühlrippen, wie bspw. in den Ausführungsbeispielen der Figuren 3 und 5 zu erkennen ist. Die Kühlelemente 15 können vorzugsweise wenigstens in einem Bereich, in dem der Kühlkörper 10 aus der Aussparung 21 des Rahmenträgers 20 hervorsteht, vorgesehen sein, wie dies in Figur 5 gezeigt ist. Es ist zusätzlich oder alternativ (vgl. Figur 3) denkbar, dass die Kühlelemente 15 in einem Bereich des Kühlkörpers 10 vorgesehen sind, in dem dieser wenigstens teilweise von der den Kühlkörper 10 aufnehmenden Aussparung 21 des Trägers 20 (seitlich) umgeben ist. Vorzugsweise erstrecken sich die Kühlelemente 15 quer zum Träger 20, wie in den Figuren 3 und 5 gezeigt ist. Gemäß der Ausführungsform der Figur 3 schließt dabei die maximale Erstreckung der Kühlelemente 15 (und somit der Kühlkörper 10 selbst) bündig mit dem Träger 20 ab. Zusätzlich oder alternativ zu den vorgenannten Ausgestaltungsformen können die Kühlelemente 15 auf den Seitenwänden bzw. der Mantelfläche M des Kühlkörpers 10 bzw. die Mantelfläche M des Kühlkörpers 10 bildend vorgesehen bzw. ausgebildet sein. Erstrecken sich die Kühlelemente 15 des Kühlkörpers 10 wenigstens teilweise auf einem Bereich der Mantelfläche M des Kühlkörpers 10, welcher (seitlich) von der Aussparung 21 umgeben ist, so sind die Kühlrippen 15 vorzugsweise derart ausgebildet, dass der durch die Kühlrippen 15 (also dessen maximale Erstreckung) gebildete Außenumfang des Kühlkörpers 10 eine Kontur aufweist, welche derjenigen der Aussparung 21 entspricht, so dass der Kühlkörper 10 einfach in vorbeschriebener Weise in die Aussparung 21 eingesetzt werden kann.

Die Kombination aus Träger 20 und Kühlkörper 10 stellt einen Leiterplatten-Hybridaufbau dar, welcher für sich genommen den zweiten Aspekt der Erfindung bestimmt.

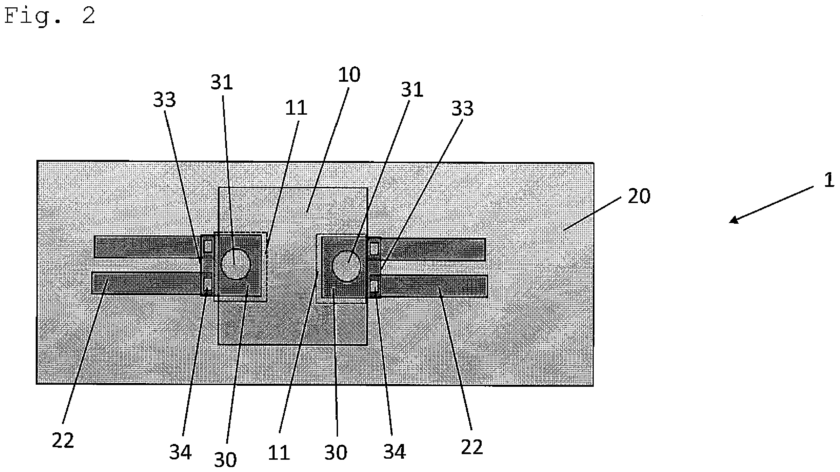

Gemäß dem ersten Aspekt der Erfindung weist der Leiterplatten-Hybridaufbau (bzw. die LED-Anordnung 1) ferner wenigstens ein LED-Modul 30 (vgl. Figur 1 und 3 bis 5) oder mehrere LED-Module 30 (vgl. Figur 2) auf, welche(s) über den Rahmenträger 20 elektrisch kontaktiert ist/sind, wie im Weiteren noch erläutert wird. Die Kombination aus Träger 20, Kühlkörper 10 und LED-Modul 30 stellt die ebenfalls erfindungsgemäße LED-Anordnung 1 dar. Das LED-Modul 30 weist LED-Komponenten 31 auf, die insbesondere wenigstens einen oder mehrere LED-Chips umfassen. Die LED-Chips können monochromatische gleichfarbige oder verschiedenfarbige LED-Chips sein. Die LED-Chips können mit einem bspw. durch ein Dispensverfahren aufgebrachten Globe-Top oder einer anderen Abdeckung abgedeckt sein, welche vorzugsweise Farbkonversionspartikel (Leuchtstoff) oder Streupartikel aufweist. Insbesondere können die LED-Chips wenigstens eine blaue oder UV-LED aufweisen, deren Licht durch eine Farbkonversionsschicht, die oberhalb und vorzugsweise in direktem Kontakt mit sämtlichen LEDs angeordnet ist, teilweise in Licht mit anderer Wellenlänge umgesetzt wird, wobei das Mischlicht vorzugsweise im weißen Spektrum liegt. Des Weiteren kann ein Reflektorelement oder eine Reflektorschicht vorgesehen sein.

Das LED-Modul 30 ist derart vorgesehen, dass es wenigstens seitlich, also wenigstens mit einer oder einem Teilbereich einer seiner vier Seiten 32, 33, mit dem Kühlkörper 10 thermisch kontaktiert ist. Auf diese Weise kann bei geringer Bauhöhe gleichzeitig ein guter Wärmefluss von dem LED-Modul 30 zum Kühlkörper 10 gewährleistet werden. Vorzugsweise erstreckt sich, wie in den Figuren 3 bis 5 gezeigt, der Kühlkörper 10 auf der Seite 26 des Trägers 20, auf der auch das LED-Modul 30 vorgesehen ist, maximal soweit von dem Träger 20 wie das LED-Modul 30, so dass die Bauhöhe durch das Vorsehen des Kühlkörpers 10 nicht beeinträchtigt wird. Vorzugsweise sind die vom Träger 20 abgewandten Seiten 16, 36 des Kühlkörpers 10 und des LED-Moduls 30 im Wesentlichen bündig (vgl. Figuren 3 bis 5).

In der erfindungsgemäßen Ausgestaltungsform weist der Kühlkörper 10 wenigstens eine Ausnehmung 11 auf, in der das LED-Modul 30 wenigstens teilweise eingesetzt ist. Die Ausnehmung 11 ist dabei vorzugsweise in dem sich von dem Träger 20 weg erstreckenden Bereich des Kühlkörpers 10 vorgesehen. Der Boden 14 der Ausnehmung 11 erstreckt sich vorzugsweise in Verlängerung der Trägeroberfläche auf der Seite 26 des Trägers 20, auf der auch das LED-Modul 30 vorgesehen ist. Die Ausnehmung 11 weist wenigstens zwei (in den Figuren 1 und 2: je drei) Wände 13 auf, so dass das LED-Modul 30 in der Ausnehmung 11 des Kühlkörpers 10 wenigstens teilweise seitlich von diesem umgeben und vorzugsweise mit den Wänden 13 bzw. wenigstens einem Teil oder Teilbereich der Wände 13 des Kühlkörpers 10 thermisch kontaktiert ist. Die durch das LED-Modul 30 erzeugte Wärme kann somit direkt über ihre Seitenwände 32 an den in den Träger 20 integrierten Kühlkörper 10 abgeführt werden.

Wie zuvor beschrieben, ist das LED-Modul 30 an wenigstens einer oder einem Teilbereich wenigstens einer seiner Seiten 32, 33 mit dem Kühlkörper 10 in thermischem, vorzugsweise flächigem Kontakt. Figuren 1 und 2 zeigen Ausführungsbeispiele, gemäß denen der Kühlkörper 10 wenigstens eine Ausnehmung 11 aufweist, in die das LED-Modul 30 wenigstens teilweise eingesetzt ist. In diesem Fall ist das LED-Modul 30 gemäß der vorliegenden Erfindung an wenigstens zwei (in Figuren 1 und 2: drei) Seiten 32, 33 oder wenigstens Teilbereichen derselben mit dem Kühlkörper 10, also mit den die Ausnehmung 11 umgebenden Wänden 13, in thermischem, vorzugsweise flächigem Kontakt. Das LED-Modul 10 ist gemäß den Figuren 1 und 2 also vorzugsweise an drei Seiten 32 von dem Kühlkörper 10 seitlich umgeben. Die vierte Seite 33 des LED-Moduls 30 weist von dem Kühlkörper 10 bzw. der Ausnehmung 11 weg in Richtung Träger(material) 20. Die vierte Seite 33 hat in dem Ausführungsbeispiel gemäß der Figuren 1 und 2 also keine thermische Anbindung an den Kühlkörper 10 und dient vorzugsweise der elektrischen Kontaktierung des LED-Moduls 30 über den Träger 20, wie im Folgenden noch näher erläutert wird. Es ist jedoch auch denkbar, dass auch die vierte Seite 33 wenigstens teilweise mit dem Kühlkörper 10 in thermischen Kontakt steht; bspw. in Form einer seitlichen Hintergreifung. Sind alle Seiten 32, 33 des LED-Moduls 30 rundherum in Kontakt mit dem Kühlkörper 10, bildet die Ausnehmung 11 eine Vertiefung in dem Kühlkörper 10, in die das LED-Modul 30 eingesetzt werden kann.

Die Ausnehmung 11 des Kühlkörpers 10 kann derart ausgebildet sein, dass das LED-Modul 30 in die Ausnehmung 11 derart eingelegt bzw. eingedrückt werden kann, dass es in der Ausnehmung 11 mechanisch fixiert ist; bspw. verrastet oder verklemmt. Hierzu entspricht die Querschnittsform der Ausnehmung 11 vorzugsweise der Kontur des LED-Moduls 30 bzw. der in dem Kühlkörper 10 angeordneten Teilbereiche des LED-Moduls 30, um insbesondere auch einen möglichst großen flächigen Kontakt zur Wärmeübertragung bereitzustellen.

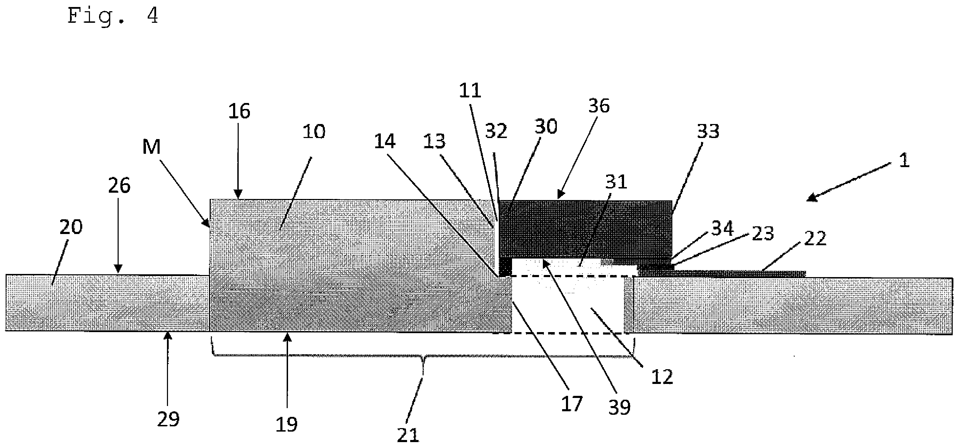

Wie in den Figuren 1 bis 5 gezeigt ist, ist das LED-Modul 30 vorzugsweise wenigstens teilweise (vgl. Figuren 4 und 5) oder ganz (vgl. Figur 3) auf dem Kühlkörper 10 vorgesehen, also aufgebracht, um neben der lateralen thermischen Kontaktierung eine weitere thermische Kontaktierung bereitzustellen. Diese weitere thermische Kontaktierung wird vorzugsweise durch den Bodenbereich 14 der Ausnehmung 11 bereitgestellt.

Es sei an dieser Stelle angemerkt, dass die thermische Kontaktierung des LED-Moduls 30 mit dem Kühlkörper 10 vorzugsweise durch flächigen Kontakt der beiden Elemente erreicht wird. Ebenso ist es vorteilhaft, wenn die Oberfläche der das LED-Modul 30 aufweisenden Seite 26 des Rahmenträgers 20 im Wesentlichen plan ist, um einen möglichst flächigen Kontakt zwischen LED-Modul 30 bzw. Teilen davon und der Trägeroberfläche zu ermöglichen, wenn das LED-Modul 30 bspw. seitlich über den Kühlkörper 10 hinausragt, wie im Folgenden beschrieben. Dies kann zu einer weiteren Verbesserung der Wärmeabfuhr führen.

Das LED-Modul 30 ist vorzugsweise derart in der Ausnehmung 11 des Kühlkörpers 10 vorgesehen bzw. angeordnet, dass es wenigstens zum Teil (also bspw. wenigstens mit seiner vierten, nicht thermisch kontaktierten Seite 33) seitlich über den Kühlkörper 10 hinausragt und sich somit teilweise über den Träger 20 erstreckt. Das LED-Modul 30 kommt also vorzugsweise teilweise über dem Träger 20 zum Liegen bzw. ist über dem Träger 20 positioniert, wie dies in den Figuren 1 und 2 und insbesondere in den Figuren 4 und 5 zu erkennen ist. Der dem Träger 20 gegenüberliegende bzw. zugewandte Teil(-bereich) des LED-Moduls 30 dient dann vorzugsweise zur elektrischen Kontaktierung des LED-Moduls 30 über den Träger 20. Folglich sind in einer bevorzugten Ausgestaltungsform alle erforderlichen Kontaktpads 34 des LED-Moduls 30 auf dieser Fläche vorgesehen, welche mit auf dem Träger 20 vorgesehenen Leiterzügen bzw. Leiterbahnen 22 bspw. über Lötstellen 23 kontaktiert sind (vgl. Figuren 4 und 5). Somit kann das LED-Modul 30 durch Oberflächenmontage (Surface Mounted Technology; SMT) als oberflächenmontiertes Bauelement (Surface Mounted Device; SMD) auf dem Träger 20 montiert werden, während gleichzeitig eine große thermische Kontaktfläche zu dem in dem Träger 20 eingesetzten Kühlkörper 10 bereitgestellt ist. Durch diesen Aufbau kann das LED-Modul 30 als SMD-Bauteil direkt auf den Träger 20 gelötet werden, während keine zusätzlichen Verbindungen (z.B. Bonddrähte) benötigt werden. Neben der Oberflächenmontage (über Lötverbindungen) ist es grundsätzlich auch denkbar, das LED-Modul 30 in anderer Weise elektrisch zu kontaktieren; bspw. mittels Bonddrähten 25 (vgl. Figur 3; Bonddrahtmontage) oder dergleichen. Die Bonddrahtmontage bietet sich insbesondere auch dann an, wenn das LED-Modul 30 vollständig von der eine Vertiefung im Kühlkörper 10 bildenden Ausnehmung 11 seitlich umgeben ist.

Für einen verbesserten Wärmeübergang von dem LED-Modul 30 zu dem Kühlkörper 10 bzw. auch zu dem Träger 20, kann das LED-Modul 30 mittels eines gut wärmeleitenden Klebers auf dem Rahmenträger 20 bzw. auf dem/in den Kühlkörper aufgebracht bzw. vorgesehen werden.

Es wurde zuvor bereits beschrieben, dass das LED-Modul 30 wenigstens eine LED bzw. einen LED-Chip 31 aufweisen kann. Gemäß einem ersten Ausführungsbeispiel der Erfindung ist das LED-Modul 30 derart vorgesehen, dass der wenigstens eine LED-Chip bzw. die LED-Komponenten 31 auf der dem Träger 20 abgewandten Seite 36 des LED-Moduls 30 vorgesehen sind, wie auch in den Figuren 1 bis 3 gezeigt, so dass das LED-Modul 30 von dem Rahmenträger 20 weg abstrahlt. Bei dieser Ausführungsform kann das LED-Modul 30 sowohl seitlich neben dem Kühlkörper 10 auf dem Träger 20 vorgesehen sein, oder aber auch wenigstens teilweise auf dem Kühlkörper 10, genauer in einer Ausnehmung 11 des Kühlkörpers 10 vorgesehen sein. Gemäß Figur 3 ist das LED-Modul 30 ganz auf dem Kühlkörper 10 bzw. in dessen Ausnehmung 11 angeordnet. In allen Fällen besteht wenigstens ein seitlicher thermischer Kontakt zwischen LED-Modul 30 und Kühlkörper 10. Ist das LED-Modul 30 derart vorgesehen, dass es von dem Rahmenträger 20 weg abstrahlt, so sind eventuell vorgesehene Kühlrippen 15 vorzugsweise auf der in Abstrahlrichtung gesehen rückwärtigen Seite 19 des Kühlkörpers 10 und ferner vorzugsweise bündig mit der bzgl. des LED-Moduls 30 abgewandten Seite 29 des Trägers 20 angeordnet, wie dies in Figur 3 gezeigt ist.

Gemäß einem zweiten, bevorzugten Ausführungsbeispiel der Erfindung, wie in den Figuren 4 und 5 gezeigt, weist der Kühlkörper 10 eine sich vorzugsweise im Wesentlichen senkrecht zum Träger 20 erstreckende, durchgehende Öffnung 12 auf. Die die Öffnung 12 bildenden Kühlkörperwände verkleiden somit die Wände der Aussparung 21 in dem Träger 20. Wie den Figuren 4 und 5 zu entnehmen ist, kann das LED-Modul 30 in diesem Fall vorzugsweise mittels Oberflächenmontage (SMT) derart vorgesehen sein, dass der LED-Chip bzw. die LED-Komponenten 31 auf der dem Träger 20 zugewandten Seite 39 des LED-Moduls 30 derart vorgesehen ist/sind, dass der LED-Chip 31 durch die Öffnung 12 hindurch abstrahlt. In einer besonders bevorzugten Ausgestaltungsform ragt hierzu wenigstens der LED-Chip und ggf. ein diesen überdeckender Globe-Top (also vorzugsweise die gesamten LED-Komponenten 31 oder wenigstens ein Teil derselben) in die Öffnung 12 hinein. Somit kann das LED-Modul 30 vorzugsweise flächig auf dem Träger 20 bzw. dem Kühlkörper 10 vorgesehen sein, um eine größtmögliche Wärmeabfuhr zu ermöglichen und somit den Wirkungsgrad der LED-Anordnung 1 zu erhöhen. Vorzugsweise ist das LED-Modul 30 in dieser Ausgestaltungsform direkt mit der Trägerplatte 20 kontaktiert, bspw. über die vorbeschriebenen Kontaktpads 34, Lötstelle 23 und Leiterbahnen 22.

Um eine effektive und homogene Lichtabstrahlung zu ermöglichen, können die Seitenwände 17 der Öffnung 12 reflektiv, vorzugsweise hochreflektiv ausgebildet sein. Dies kann entweder durch das Material (bspw. Aluminium) des Kühlkörpers 10 selbst erzielt werden. Es ist aber alternativ oder zusätzlich denkbar, die Seitenwände 17 der Öffnung 12 nachzubehandeln oder mit einer zusätzlichen Beschichtung aus einem hochreflektiven Material (z.B. Silber oder ein anderes Material bspw. aufweisend Titandioxid-Pigmente) zu beschichten.

Grundsätzlich ist es auch denkbar, die Öffnung 12 in Abstrahlrichtung des LED-Moduls 30 vor dem LED-Chip 31 mit einem optischen Element 60 zu versehen und/oder die Öffnung 12 bspw. mit einem Matrixmaterial auszufüllen, wobei das optische Element 60 bzw. das Matrixmaterial Streupartikel und/oder Farbkonversionspartikel (Leuchtstoffe) aufweisen können. Das optische Element 60 kann bspw. eine Linse sein, welche vor (vgl. Figur 5) die Öffnung 12 auf der dem LED-Modul 30 gegenüberliegenden Seite 29 des Trägers 20 oder in der Öffnung 12 selbst vorgesehen ist. Das optische Element 60 (z.B. eine Linse) kann hierzu bspw. auf die dem LED-Modul 30 gegenüberliegenden Seite 29 des Trägers 20 und/oder die damit vorzugsweise bündig verlaufende Seite 19 des Kühlkörpers 10 angebracht, bspw. geklebt werden. Mit Verweis auf Figur 5 ist es jedoch auch denkbar, dass der Kühlkörper 10 Aufnahmevorrichtungen 18 aufweist, die mit korrespondierenden Aufnahmevorrichtungen 61 des optischen Elements 60 derart zusammenwirken, dass das optische Element 60 in einfacher Weise exakt zu dem LED-Modul 30, insbesondere den LED-Komponenten 31, positioniert ist. Die Aufnahmevorrichtungen 18, 61 können bspw. eine Vertiefung 18 in dem Kühlkörper 10 umfassen, in die entsprechend korrespondierende Erhebungen 61 (bspw. Stifte) des optischen Elements 60 eingeführt und miteinander fixiert werden können; bspw. mittels Kleber oder einer Verrastung (bspw. durch Hinterschnitt in der Vertiefung 18) oder dergleichen.

Zudem ist es denkbar, insbesondere bei einem Ausführungsbeispiel gemäß der Figur 1 oder 2, bei denen das LED-Modul 30 von dem Träger 20 weg abstrahlt, dass auch die Seitenwände M des Kühlkörpers 10 bzw. die Seitenwände 13 in der Ausnehmung 11 des Kühlkörpers 10 wenigstens teilweise hochreflektierend ausgebildet sind. Dies kann ebenfalls durch das Material des Kühlkörpers 10, eine Nachbehandlung oder eine Beschichtung der Seitenwände M, 13 in oben beschriebener Weise erzielt werden.

Im Folgenden wird ein Verfahren zum integrierten Vorsehen eines Kühlkörpers 10 in einer LED-Anordnung 1 beschrieben.

Zunächst wird ein Träger 20, beispielsweise eine FR4-Leiterplatte, bereitgestellt, in welcher eine Aussparung 21 vorgesehen ist. In die Aussparung 21 wird sodann ein Kühlkörper 10 eingesetzt. Anschließend wird ein LED-Modul 30 derart vorgesehen, dass es einerseits über den Träger 20 elektrisch kontaktiert und andererseits mit dem integriert vorgesehenen Kühlkörper 10 wenigstens seitlich in thermischen Kontakt gebracht wird. Der Kühlkörper 10 kann eine vorbeschriebene Ausnehmung 11 aufweisen, in die das LED-Modul 30 wenigstens teilweise eingesetzt wird, um einen thermischen Kontakt zwischen LED-Modul 30 und Kühlkörper 11 sowie vorzugsweise auch eine mechanische Fixierung des LED-Moduls 30 in der LED-Anordnung 1 zu erzielen. Das LED-Modul 30 kann mittels eines gut Wärme-leitenden Klebers befestigt werden. Das LED-Modul 30 kann derart vorgesehen werden, dass es von dem Träger 20 weg abstrahlt; also die LED-Komponenten 31 auf der dem Träger 20 abgewandten Seite 36 des LED-Moduls 30 vorgesehen sind. Alternativ kann das LED-Modul 30 auch derart vorgesehen werden, dass seine LED-Komponenten 31 dem Träger 20 zugewandt sind. In diesem Fall weist der Kühlkörper 10 eine sich im Wesentlichen senkrecht zum Träger 20 erstreckende, durchgehende Öffnung 12 auf, durch die das LED-Modul 30 abstrahlt, wobei wenigstens ein Teil der LED-Komponenten 31 in die Öffnung 12 hineinragen kann. Der Kühlkörper 10 kann Kühlelemente 15 aufweisen, vorzugsweise Kühlrippen. Die Kühlelemente 15 sind vorzugsweise in einem Bereich, in dem der Kühlkörper 10 aus der Aussparung 21 des Rahmenträgers 20 hervorsteht und/oder von der Aussparung 21 seitlich umgeben ist, auf seiner Mantelfläche M und/oder an seinen im Wesentlichen parallel zum Träger 20 ausgerichteten Stirnflächen 16, 19, vorzugsweise bzgl. der Abstrahlrichtung des LED-Moduls 30 wenigstens auf einer rückwärtigen Seite (Seite 19 in Figur 3; Seite 16 in Figur 5) des Kühlkörpers 10 bzgl. des LED-Moduls 30, vorgesehen; entweder zusätzlich oder durch integrale Ausbildung. Ferner können optische Elemente 60 vorgesehen werden, die in Abstrahlrichtung vor dem LED-Modul 30 bzw. den LED-Komponenten 31 angeordnet sind und ggf. zusätzlich Streupartikel und/oder Leuchtstoffe aufweisen.

Die Erfindung ist nicht auf die zuvor beschriebenen Ausführungsbeispiele beschränkt, solange sie vom Gegenstand der folgenden Ansprüche umfasst ist. Zudem sind die Merkmale aller Ausführungsbeispiele beliebig untereinander kombinierbar. So kann jedes Ausführungsbeispiel eine Kontaktierung des LED-Moduls 30 mittels Drahtverbindung 25 oder direkter Kontaktierung aufweisen. Ebenso kann der Kühlkörper 10 an beliebiger Stelle Kühlelemente 15 aufweisen. Des Weiteren können optische Elemente 60 vorzugsweise in Abstrahlrichtung der LED-Komponenten 31 gesehen vor dem LED-Modul 30 angeordnet sein.

Sind mehrere LED-Module 30 vorgesehen, so können diese einzeln oder in Gruppen mit einem oder mehrere Kühlkörpern 10 in thermischem, vorzugsweise flächigem Kontakt stehen. Stehen mehrere LED-Module 30 mit einem Kühlkörper 10 in thermischem Kontakt, so können die LED-Module 30 bzgl. des Kühlkörpers 10 "nur" seitlich zu diesem platziert oder einige oder alle auch in einer oder mehreren Ausnehmungen 11 des Kühlkörpers 10 wenigstens teilweise oder ganz angeordnet sein. Mehrere LED-Module 30 können zudem mit einem einzigen oder mehreren optischen Elementen 60 versehen sein. Zudem können die LED-Module 30 alle in dieselbe Richtung oder in unterschiedliche, vorzugsweise entgegengesetzte Richtungen abstrahlen; so kann bspw. ein Teil der LED-Module 30 von der Trägerplatte 20 weg und andere durch die Trägerplatte 20 hindurch, bspw. via die durchgehende Öffnung 12, abstrahlen.

Des Weiteren ist die Kombination aus Träger 20 und Kühlkörper 10 ohne LED-Modul 30 ebenfalls von der Erfindung umfasst, solange diese Kombination (Leiterplatten-Hybridaufbau) bevorzugt dafür geeignet ist, ein oder mehrere LED-Module 30 gemäß vorhergehender Beschreibung vorzusehen.

## Patentansprüche

1. LED-Anordnung (1) aufweisend:
- einen Rahmenträger (20), insbesondere eine Leiterplatte,
- einen Kühlkörper (10), welcher in einer Aussparung (21) in dem Rahmenträger (20) vorgesehen ist, und
- wenigstens ein LED-Modul (30), welches über den Rahmenträger (20) elektrisch kontaktiert und wenigstens seitlich mit dem Kühlkörper (10) thermisch kontaktiert ist, um einen guten Wärmefluss von dem LED-Modul (30) zum Kühlkörper (10) zu gewährleisten, wobei das LED-Modul (30) in einer Ausnehmung (11) des Kühlkörpers (10) angeordnet ist und von diesem an wenigstens zwei Seiten (32, 33) seitlich umgeben und thermisch kontaktiert ist,
**dadurch gekennzeichnet, dass** der Kühlkörper (10) an der Seite des Rahmenträgers (20), an der das LED-Modul (30) vorgesehen ist, vom Rahmenträger (20) hervorsteht.

2. LED-Anordnung (1) nach Anspruch 1, wobei die Ausnehmung (11) derart
ausgebildet ist, dass das LED-Modul (30) in diese derart einlegbar bzw. eingedrückbar ist, dass es in der Ausnehmung (11) mechanisch fixiert ist, wobei die Querschnittsform der Ausnehmung (11) vorzugsweise der Kontur des LED-Moduls (30) entspricht.

3. LED-Anordnung (1) nach einem der vorhergehenden Ansprüche, wobei das LED-Modul (30) mittels Bonddrahtmontage oder Oberflächenmontage auf dem Träger (20) befestigt ist.

4. LED-Anordnung (1) nach einem der vorhergehenden Ansprüche, wobei ein Teil der dem Rahmenträger (20) zugewandten Fläche (33) des LED-Moduls (30) über dem Rahmenträger (20) positioniert ist, wobei in dem überlappenden Bereich vorzugsweise Kontaktelemente (34) des LED-Moduls (30) vorgesehen sind, welche mit Leiterbahnen (22) des Rahmenträgers (20) elektrisch kontaktiert sind.

5. LED-Anordnung (1) nach einem der vorhergehenden Ansprüche, wobei das LED-Modul (30) wenigstens einen LED-Chip (31) aufweist, welcher auf der dem Rahmenträger (20) abgewandten Seite (36) des LED-Moduls (30) vorgesehen ist und von dem Rahmenträger (20) weg abstrahlt.

6. LED-Anordnung (1) nach einem der Ansprüche 1 bis 4, wobei der Kühlkörper (10) eine sich im Wesentlichen senkrecht zum Träger (20) erstreckende, durchgehende Öffnung (12) aufweist, und wobei das LED-Modul (30) wenigstens einen LED-Chip (31) aufweist, welcher auf der dem Rahmenträger (20) zugewandten Seite (39) des LED-Moduls (30) derart vorgesehen ist, dass der LED-Chip (31) durch die Öffnung (12) hindurch abstrahlt, wobei vorzugsweise wenigstens der LED-Chip (31) und ggf. ein diesen überdeckender Globe-Top in die Öffnung (12) hineinragt.

7. LED-Anordnung (1) nach einem der vorhergehenden Ansprüche, wobei der Kühlkörper (10) die Wände der Aussparung (21) des Rahmenträgers (20) flächig kontaktieren.

8. LED-Anordnung (1) nach einem der vorhergehenden Ansprüche, wobei die Seitenwände (M) des Kühlkörpers (10) und/oder die Seitenwände (13) in der Ausnehmung (11) des Kühlkörpers (10) und/oder die Seitenwände (17) in der Öffnung (12) des Kühlkörpers (10) hochreflektierend ausgebildet sind, wobei die Reflektivität vorzugsweise durch das Material des Kühlkörpers (10) selbst, ggf. nach einer Nachbehandlung, oder durch eine zusätzliche Beschichtung erzielt wird.

9. LED-Anordnung (1) nach einem der vorhergehenden Ansprüche, wobei der Kühlkörper (10) mittels Einpressen, Laminieren oder Kleben in die Aussparung (21) des Rahmenträges (20) eingesetzt ist.

10. LED-Anordnung (1) nach einem der vorhergehenden Ansprüche, wobei der Kühlkörper (10) Kühlelemente (15) aufweist, vorzugsweise Kühlrippen, wobei die Kühlelemente (15) vorzugsweise in einem Bereich, in dem der Kühlkörper (10) aus der Aussparung (21) des Rahmenträgers (20) hervorsteht und/oder von der Aussparung (21) seitlich umgeben ist, auf seiner Mantelfläche (M) und/oder an seinen im Wesentlichen parallel zum Träger (20) ausgerichteten Stirnflächen (16, 19), vorzugsweise bzgl. der Abstrahlrichtung des LED-Moduls (30) wenigstens auf einer rückwärtigen Seite (16, 19) des Kühlkörpers (10) bzgl. des LED-Moduls (30), vorgesehen sind.

11. LED-Anordnung (1) nach einem der vorhergehenden Ansprüche, wobei die Oberfläche der das LED-Modul (30) aufweisenden Seite (26) des Rahmenträgers (20) im Wesentlichen plan ist.

12. Rahmenträger (20) für ein LED-Modul (30), insbesondere eine Leiterplatte, aufweisend einen Kühlkörper (10), welcher in einer Aussparung (21) in dem Rahmenträger (20) derart vorgesehen ist, dass ein über den Rahmenträger (20) elektrisch kontaktiertes LED-Modul (30) wenigstens seitlich mit dem Kühlkörper (10) thermisch kontaktiert sein kann, um einen guten Wärmefluss von dem LED-Modul (30) zum Kühlkörper (10) zu gewährleisten, wobei der Kühlkörper (10) eine Ausnehmung (11) aufweist, in das das LED-Modul (30) anordenbar ist, um vom Kühlkörper (10) an wenigstens zwei Seiten (32, 33) seitlich umgeben und thermisch kontaktiert zu werden, **dadurch gekennzeichnet, dass** der Kühlkörper (10) an der Seite (26) des Rahmenträgers (20), an der das LED-Modul (30) anordenbar ist, vom Rahmenträger (20) hervorsteht.

13. Rahmenträger (20) nach Anspruch 12, wobei der Kühlkörper (10) eine sich im Wesentlichen senkrecht zum Träger (20) erstreckende, durchgehende Öffnung (12) aufweist, durch die ein LED-Modul (30) abstrahlen kann.

14. Rahmenträger (20) nach einem der Ansprüche 12 oder 13, wobei die Seitenwände (M) des Kühlkörpers (10) und/oder die Seitenwände (13) in der Ausnehmung (11) des Kühlkörpers (10) und/oder die Seitenwände (17) in der Öffnung (12) des Kühlkörpers (10) hochreflektierend ausgebildet sind, wobei die Reflektivität vorzugsweise durch das Material des Kühlkörpers (10) selbst, ggf. nach einer Nachbehandlung, oder durch eine zusätzliche Beschichtung erzielt wird.

15. Rahmenträger (20) nach einem der Ansprüche 12 bis 14, wobei der Kühlkörper (10) Kühlelemente (15) aufweist, vorzugsweise Kühlrippen, wobei die Kühlelemente (15) vorzugsweise in einem Bereich, in dem der Kühlkörper (10) aus der Aussparung (21) des Rahmenträgers (20) hervorsteht und/oder von der Aussparung (21) seitlich umgeben ist, auf seiner Mantelfläche (M) und/oder an seinen im Wesentlichen parallel zum Träger (20) ausgerichteten Stirnflächen (16, 19), vorzugsweise bzgl. der Abstrahlrichtung des LED-Moduls (30) wenigstens auf einer rückwärtigen Seite (16, 19) des Kühlkörpers (10) bzgl. des LED-Moduls (30), vorgesehen sind.

## Claims

1. LED arrangement (1) comprising:
- a frame support (20), in particular a printed circuit board,
- a heat sink (10) which is provided in a recess (21) in the frame support (20), and
- at least one LED module (30), which is electrically contacted via the frame support (20) and is thermally contacted at least laterally with the heat sink (10) in order to ensure good heat flow from the LED module (30) to the heat sink (10),
wherein the LED module (30) is arranged in a recess of the heat sink (10), and is laterally surrounded and hermetically contacted therefrom by at least two sides (32, 33),
**characterized in that**
the heat sink (10) projects from the frame support (20) on the side of the frame support (20) on which the LED module (30) protrudes.

2. LED arrangement according to claim 1,
wherein the LED module (30) may be inserted or pressed into the recess (11) in such a way that it is mechanically fixed in it,
wherein the cross-sectional shape of the recess (11) preferably corresponds to the contour of the LED module (30).

3. LED arrangement (1) according to one of the preceding claims, wherein the LED module (30) is attached to the frame support (20) by means of bonding wire mounting or surface mounting.

4. LED arrangement (1) according to one of the preceding claims, wherein a part of the surface (33) of the LED module (30) facing the frame carrier (20) is positioned above the frame support (20), wherein contact elements (34) of the LED module (30) are preferably provided in the overlapping area, and are electrically connected to conductor tracks (22) of the frame support (20).

5. LED arrangement (1) according to one of the preceding claims, wherein the LED module (30) comprises at least one LED chip (31) which is arranged on the side (36) of the LED module (30) facing away from the frame support (20), and radiates away from the frame support (20).

6. LED arrangement (1) according to one of the claims 1 to 4, wherein the heat sink (10) has a through-opening (12) extending essentially perpendicularly to the frame support (20), and wherein the LED module (30) comprises at least one LED chip (31) which is provided on the side of the LED module (30) facing the frame support (20) in such a way that the LED chip (31) radiates through the opening (12), preferably wherein at least the LED chip (31) and possibly a globe top covering it, projects into the opening (12).

7. LED arrangement (1) according to one of the preceding claims, wherein the heat sink (10) contacts the walls of the recess (21) of the frame support (20) in a planar manner.

8. LED arrangement (1) according to one of the preceding claims, wherein the side walls (11) of the heat sink (10) and/or the side walls (13) are formed in the recess (11) of the heat sink (10) and/or the side wall (17) in the opening (12) of the heat sink (10) to be highly reflective, wherein the reflectivity is preferably achieved by the material of the heat sink (10) itself, optionally after a post treatment, or by an additional coating.

9. LED arrangement (1) according to one of the preceding claims, wherein the heat sink (10) is inserted into the recess (21) of the frame support (20) by means of pressing, laminating or gluing.

10. LED arrangement (1) according to one of the preceding claims, wherein the heat sink (10) comprises cooling elements (15), preferably cooling ribs, wherein the cooling elements (15) are preferably arranged in a region in which the heat sink (10) protrudes from the recess (21) of the frame support (20) and/or laterally around the recess (21) on its sleeve surface (M) and/or on its end surface (16, 19), which is aligned essentially parallel to the frame support (20), preferably with respect to the radiation direction of the LED module (30), at least on one side (16, 19) of the heat sink (10) facing rearwards with respect to the LED module (30).

11. LED arrangement (1) according to one of the preceding claims, wherein the surface of the side (26) of the frame support (20) comprising the LED module (30) is essentially planar.

12. Frame support (20) for an LED module (30), in particular a printed circuit board, comprising a heat sink (10), which is provided in a recess (21) in the frame support (20) in such a way that an LED module (30) electrically contacting via the frame support (20) may be thermally contacted at least laterally with the heat sink (10), in order to ensure a good heat flow from the LED module (30) to the heat sink (10),
wherein the heat sink (10) has a recess (11) into which the LED module (30) may be arranged, in order to be laterally surrounded and thermally contacted by the heat sink (10) on at least two sides (32, 33),
**characterized in that**
the heat sink (10) projects from the frame support (20) on the side (26) of the frame support (20) on which the LED module (30) may be arranged.

13. Frame support (20) according to claim 12, wherein the heat sink (10) has a through-opening (12) extending essentially perpendicularly to the frame support (20), through which an LED module (30) may radiate.

14. Frame support (20) according to claim 12 or 13, wherein the side walls (M) of the heat sink (10) and/or the side walls (13) are formed in the recess (11) of the heat sink (10) and/or the side walls (17) are formed to be highly reflective in the opening (12) of the heat sink (10), wherein the reflectivity is preferably achieved by the Material of the heat sink (10) itself, optionally after a post treatment, or by an additional coating.

15. Frame support (20) according to claim 12-14, wherein the heat sink (10) comprises cooling elements (15), preferably cooling ribs, wherein the cooling elements (15) are preferably arranged in a region in which the heat sink (10) protrudes from the recess (21) of the frame support (20), and/or laterally around the recess (21), on its sleeve surface (M) and/or on its end surface (16, 19), which is aligned essentially parallel to the frame support (20), preferably with respect to the radiation direction of the LED module (30), at least on one side (16, 19) of the heat sink (10) facing rearwards with respect to the LED module (30).

## Revendications

1. Ensemble de LED (1), présentant :
- un support cadre (20), en particulier une carte de circuit imprimé,
- un corps de refroidissement (10), qui est prévu dans un évidement (21) dans le support cadre (20), et
- au moins un module de LED (30) qui est mis en contact électrique par le biais du support cadre (20) et qui est mis en contact thermique avec le corps de refroidissement (10) au moins latéralement afin d'assurer un bon flux thermique à partir du module de LED (30) vers le corps de refroidissement (10),
le module de LED (30) étant disposé dans un évidement (11) du corps de refroidissement (10) et étant entouré latéralement par celui-ci sur au moins deux côtés (32, 33) et mis en contact thermique,
**caractérisé en ce que** le corps de refroidissement (10) dépasse du support cadre (20) sur le côté du support cadre (20) sur lequel est prévu le module de LED (30).

2. Ensemble de LED (1) selon la revendication 1,
l'évidement (11) étant constitué de telle sorte que le module de LED (30) peut être inséré ou respectivement pressé dans celui-ci de telle sorte qu'il est fixé mécaniquement dans l'évidement (11), la forme de section transversale de l'évidement (11) correspondant de préférence au contour du module de LED (30).

3. Ensemble de LED (1) selon l'une des revendications précédentes, le module de LED (30) étant fixé sur le support (20) au moyen d'un montage à fils de connexion ou d'un montage en surface sur le support (20).

4. Ensemble de LED (1) selon l'une des revendications précédentes, une partie de la surface (33) du module de LED (30) tournée vers le support cadre (20) étant positionnée au-dessus du support cadre (20), des éléments de contact (34) du module de LED (30) étant de préférence prévus dans la zone en chevauchement et étant mis en contact électrique avec des pistes conductrices (22) du support cadre (20).

5. Ensemble de LED (1) selon l'une des revendications précédentes, le module de LED (30) présentant au moins une puce LED (31) qui est prévue sur le côté (36) du module de LED (30) éloigné du module de LED (30) et qui rayonne en s'éloignant du support cadre (20).

6. Ensemble de LED (1) selon l'une des revendications 1 à 4, le corps de refroidissement (10) présentant une ouverture (12) traversante s'étendant essentiellement perpendiculairement au support (20), et le module de LED (30) présentant au moins une puce LED (31) qui est prévue sur le côté (39) du module de LED (30) tourné vers le support cadre (20) de telle sorte que la puce LED (31) rayonne à travers l'ouverture (12), de préférence au moins la puce LED (31) et éventuellement un globe-top recouvrant celle-ci pénétrant dans l'ouverture (12).

7. Ensemble de LED (1) selon l'une des revendications précédentes, le corps de refroidissement (10) entrant en contact à plat avec les parois de l'évidement (21) du support cadre (20).

8. Ensemble de LED (1) selon l'une des revendications précédentes, les parois latérales (M) du corps de refroidissement (10) et/ou les parois latérales (13) dans l'évidement (11) du corps de refroidissement (10) et/ou les parois latérales (17) dans l'ouverture (12) du corps de refroidissement (10) étant constituées de façon très réfléchissante, la réflectivité étant obtenue de préférence par le matériau du corps de refroidissement (10) lui-même, éventuellement après un traitement ultérieur, ou par un revêtement supplémentaire.

9. Ensemble de LED (1) selon l'une des revendications précédentes, le corps de refroidissement (10) étant introduit dans l'évidement (21) du support cadre (20) par pressage, laminage ou collage.

10. Ensemble de LED (1) selon l'une des revendications précédentes, le corps de refroidissement (10) présentant des éléments de refroidissement (15), de préférence des ailettes de refroidissement, les éléments de refroidissement (15) étant de préférence prévus dans une zone dans laquelle le corps de refroidissement (10) dépasse de l'évidement (21) du support cadre (20) et/ou est entouré latéralement par l'évidement (21), sur sa surface d'enveloppe (M) et/ou sur ses faces frontales (16, 19) orientées essentiellement parallèlement au support (20), de préférence par rapport à la direction de rayonnement du module de LED (30) au moins sur un côté (16, 19) arrière du corps de refroidissement (10) par rapport au module de LED (30).

11. Ensemble de LED (1) selon l'une des revendications précédentes, la surface du côté (26) du support cadre (20) présentant le module de LED (30) étant essentiellement plane.

12. Support cadre (20) pour un module de LED (30), en particulier une carte de circuit imprimé, présentant un corps de refroidissement (10) qui est prévu dans un évidement (21) dans le support cadre (20) de telle sorte qu'un module de LED (30) mis en contact électrique par le biais du support cadre (20) peut, au moins latéralement, être mis en contact thermique avec le corps de refroidissement (10) pour assurer un bon flux thermique à partir du module de LED (30) vers le corps de refroidissement (10),
le corps de refroidissement (10) présentant un évidement (11) dans lequel le module de LED (30) peut être disposé pour être entouré latéralement par le corps de refroidissement (10) sur au moins deux côtés (32, 33) et pour être mis en contact thermique,
**caractérisé en ce que** le corps de refroidissement (10) dépasse du support cadre (20) sur le côté (26) du support cadre (20) sur lequel le module de LED (30) peut être disposé.

13. Support cadre (20) selon la revendication 12, le corps de refroidissement (10) présentant une ouverture (12) traversante s'étendant essentiellement perpendiculairement au support (20) à travers laquelle un module de LED (30) peut rayonner.

14. Support cadre (20) selon l'une des revendications 12 ou 13, les parois latérales (M) du corps de refroidissement (10) et/ou les parois latérales (13) dans l'évidement (11) du corps de refroidissement (10) et/ou les parois latérales (17) dans l'ouverture (12) du corps de refroidissement (10) étant constituées de façon très réfléchissante, la réflectivité étant obtenue de préférence par le matériau du corps de refroidissement (10) lui-même, éventuellement après un traitement ultérieur, ou par un revêtement supplémentaire.

15. Support cadre (20) selon l'une des revendications 12 à 14, le corps de refroidissement (10) présentant des éléments de refroidissement (15), de préférence des ailettes de refroidissement, les éléments de refroidissement (15) étant de préférence prévus dans une zone dans laquelle le corps de refroidissement (10) dépasse de l'évidement (21) du support cadre (20) et/ou est entouré latéralement par l'évidement (21), sur sa surface d'enveloppe (M) et/ou sur ses faces frontales (16, 19) orientées essentiellement parallèlement au support (20), de préférence par rapport à la direction de rayonnement du module de LED (30) au moins sur un côté (16, 19) arrière du corps de refroidissement (10) par rapport au module de LED (30).
